# EUROPEAN PATENT APPLICATION

(11) **EP 1 953 594 A1**
(43) Date of publication of application: **06.08.2008**
(21) Application number: 06832596.8
(22) Date of filing: 14.11.2006
(51) Int. Cl.: G03F 7/033, G03F 7/00

(54) **FLEXO PRINTING PLATE**

(30) Priority: 21.11.2005 JP 2005335860
(71) Applicant: Asahi Kasei Chemicals Corporation, Tokyo 100-8440 (JP)
(72) Inventor: YAMAZAWA, Kazuyoshi, Tokyo 100-8440 (JP); ARAKI, Yoshifumi, Tokyo 100-8440 (JP)
(74) Representative: Bradley, Josephine Mary
(86) International application number: PCT/JP2006/322634
(87) International publication number: WO 2007/058163

(57) **Abstract**

According to the present invention, a flexographic printing plate and a photosensitive resin composition used therein are provided. The flexographic printing plate comprises a photocured product which is obtained by photocuring a photosensitive resin composition comprising a thermoplastic elastomer (a), a photopolymerizable unsaturated monomer (b) and a photopolymerization initiator (c) and has a loss tangent (tan δ) of 0.3 or more at 500 Hz in dynamic viscoelastometry using a nonresonance forced vibration apparatus.

## Description

### Technical Field

The present invention relates to a flexographic printing plate and a photosensitive resin composition used therein.

### Background Art

A photosensitive resin composition for flexographic printing generally comprises a thermoplastic elastomer, a photopolymerizable unsaturated monomer, and a photopolymerization initiator, as described in Patent Documents 1 to 3.
A raw plate for flexographic printing is typically produced by applying the photosensitive resin composition to a support such as a polyester film, etc., and further, as needed, providing, on the resin composition, a slipping layer (protective layer) in order to, for example, achieving smooth contact with a negative film or an ultraviolet blocking layer containing an infrared-sensitive substance capable of being cut off by an infrared laser.
To prepare a flexographic printing plate from the raw plate for flexographic printing, the whole surface of the raw plate is first subjected to ultraviolet exposure (back exposure) through a support to provide a thin uniform cured layer on the support side. The surface of the photosensitive resin layer is then subjected to image exposure (relief exposure) indirectly through a negative film or directly from above the ultraviolet blocking layer. Subsequently, an unexposed portion is generally washed out with a developing solution, followed by post-exposure to produce a flexographic printing plate.

Printing using the flexographic printing plate is typically carried out using a printing press having a mechanism in which inks containing ester solvents or the like are supplied onto the surface of convex portions of the resin plate having concaves and convexes by use of an ink-supplying roll or the like, followed by bringing the printing plate into contact with a substrate to be printed to transfer the inks on the surface of the convex portions to the substrate to be printed.
Here, when the flexographic printing press has low mechanical precision and thereby generates oscillation, or when the substrate to be printed has nonuniform thickness or a concave and convex image of the printing plate is not uniform in the printing direction, the area of image portions such as halftone dots does not stay constant on printed matter, which has sometimes produced printing density unevenness to make it difficult to obtain high quality printed matter.

Thus, various studies for solving the above problems have been carried out. For example, Patent Document 4 proposes a method involving, when the side of a flexographic printing plate on which a relief image is formed is taken to be the right face thereof, disposing a foam tape having a cushion effect on the face opposite thereto (hereinafter referred to as the reverse face) via an adhesive. However, this method produces the thickening of characters and images due to the strong elasticity of the cushion when a hard foam tape is used. This method also makes insufficient the ink transfer of solid portions to a substrate to be printed when a soft foam tape is used. Thus, it is not easy to select a foam tape inducing no thickening of images and the like and making the ink transfer sufficient. In addition, the invention disclosed in Patent Document 4 is not an invention for improving a photosensitive resin layer which is a portion contacting with a substrate to be printed, and has been not necessarily sufficient in the effect of suppressing printing density unevenness.
Patent Document 5 proposes a flexographic printing plate in which a support layer having barrier performance, an adhesion layer, and a photocured resin layer are laminated on an elastic foam layer. However, the flexographic printing plate has had problems, including that it is of high cost because of its multilayer structure and that it does not enable back exposure or requires the prolonged back exposure time due to the provided cushion foam layer, which makes the formation of micro images difficult or increases the plate-making time.
Patent Document 6 proposes a flexographic printing plate in which a support layer, an underlayer containing thermally expandable capsules, and a photosensitive resin layer are laminated. However, this technique requires heat treatment for allowing the underlayer to generate bubbles, which has posed a problem of reducing production and plate-making efficiencies.
Patent Document 7 is intended to obtain a printing plate which enables the shortening of plate-making time and can print fine images, and discloses a photosensitive elastomer composition comprising a thermoplastic block copolymer, an ethylenically unsaturated compound component, and a photopolymerization initiator. The thermoplastic block copolymer comprises at least one monovinyl-substituted hydrocarbon polymer block and at least one conjugated diene block, and has a monovinyl-substituted hydrocarbon content (A) of 10 to 35% by weight and a vinyl content (V) of the conjugated diene of 20 to 50% by weight, wherein (A) and (V) satisfy a particular equation. However, this document contains no description of unevenness of printing; the resultant printing plate has had no sufficiently improved printing unevenness.

Patent Document 8 proposes a resin composition allowed to contain, in order to improve resistance to ink, 45% by weight or less of a block copolymer in a photosensitive resin composition. The block copolymer comprises at least an isoprene-containing block with a high vinyl content and a vinyl aromatic hydrocarbon-containing block, and has a loss tangent (tan δ) peak temperature ranging from -10°C to 30°C to prevent reduction in resilience. However, Patent Document 8 gives no description or indication of the density unevenness of halftone dots; this technique has also been unable to sufficiently suppress printing unevenness.
Patent Documents 9 and 10 are intended to provide photosensitive rubber plates excellent in transparency and strength balance and capable of being rapidly cleaned after exposure to light, and each disclose a photosensitive composition comprising 20 to 65 parts by weight of a block copolymer, 35 to 80 parts by weight of a hydrophilic copolymer, 5 to 300 parts by weight of a photopolymerizable ethylenically unsaturated monomer, and 0.1 to 10 parts by weight of a photopolymerization initiator. The block copolymer comprises a polymer block composed of a polymer containing an aromatic vinyl monomer unit as the main constitutional unit and a polymer block whose conjugated diene unit portion has a vinyl bond content of 15 to 70%. However, these Patent Documents 9 and 10 also contain no description of printing unevenness or a photosensitive composition capable of being dissolved with an organic solvent; the resultant printing plates have had no sufficiently improved printing unevenness.
Patent Document 11 is intended to provide a flexographic printing plate which is free of disadvantages such as excessive hardness and anisotropy and has the advantages of SBS rubber, such as low viscosity, and discloses a photopolymerizable composition comprising 50 to 90% by mass of a binder mixture, an ethylenically unsaturated monomer, a plasticizer, and a photoinitiator. The binder mixture is composed of SIS block copolymer, a thermoplastic elastomer, having a styrene content of 5 to 25% by mass and SBS block copolymer, a thermoplastic elastomer, having a styrene content of 5 to 25% by mass and a vinyl bond content of 35 to 65%, wherein the mass ratio (SBS/SIS) is 70/30 to 10/90. However, this document also contains no description of printing unevenness; the resultant printing plate has had no sufficiently improved printing unevenness.

As mentioned above, there is no document describing the relationship between particular tan δ values and printing density unevenness in dot parts and the like in flexographic printing for a photocured product of a flexographic printing photosensitive resin, based on conventional technology.
Patent Document 1: Japanese Patent Laid-Open No. 2000-155418
Patent Document 2: Japanese Patent No. 2772055
Patent Document 3: Japanese Patent No. 2635461
Patent Document 4: Japanese Patent Laid-Open No. 2004-268291
Patent Document 5: Japanese Patent Laid-Open No. 11-184072
Patent Document 6: Japanese Patent Laid-Open No. 2004-226592
Patent Document 7: Japanese Patent No. 3144870
Patent Document 8: Japanese Patent Laid-Open No. 10-104833
Patent Document 9: WO96/010218
Patent Document 10: Japanese Patent Laid-Open No. 10-031303
Patent Document 11: Japanese Patent Laid-Open No. 2002-072457

### Disclosure of the Invention

### Problems to be Solved by the Invention

An object of the present invention is to provide a flexographic printing plate capable of producing halftone dots and the like having little printing density unevenness in printed matter.

### Means for Solving the Problems

As a result of intensive studies for eliminating the above problems, the present inventors have found that the following novel photosensitive resin composition can be used to solve the problems, thereby accomplishing the present invention.
Thus, the present invention is as follows.
(1) A flexographic printing plate comprising a photocured product, wherein the photocured product is obtained by photocuring a photosensitive resin composition comprising a thermoplastic elastomer (a), a photopolymerizable unsaturated monomer (b) and a photopolymerization initiator (c) and has a loss tangent (tan δ) of 0.3 or more at 500 Hz in dynamic viscoelastometry using a nonresonance forced vibration apparatus.
(2) The flexographic printing plate described in item (1) above, wherein the thermoplastic elastomer (a) comprises at least one polymer block composed mainly of vinyl aromatic hydrocarbons and at least one polymer block composed mainly of conjugated dienes.
(3) The flexographic printing plate described in item (2) above, wherein the polymer block composed mainly of conjugated dienes has a side chain group content of 35 mole% (inclusive) to 80 mole% (inclusive).
(4) The flexographic printing plate described in item (1) above, wherein the thermoplastic elastomer (a) comprises at least one polymer block composed mainly of vinyl aromatic hydrocarbons and at least one polymer block composed mainly of butadiene and/or hydrogenated butadiene.
(5) The flexographic printing plate described in item (4) above, wherein the polymer block composed mainly of butadiene and/or hydrogenated butadiene has a side chain group content of 35 mole% (inclusive) to 80 mole% (inclusive).
(6) The flexographic printing plate described in any of items (1) to (5) above, wherein the photocured product has a loss tangent (tan δ) of 0.55 or more at 500 Hz.
(7) The flexographic printing plate described in any of items (1) to (5) above, wherein the photocured product has a loss tangent (tan δ) of 0.7 or more at 500 Hz.
(8) The flexographic printing plate described in any of items (1) to (7) above, wherein the photosensitive resin composition has a thermoplastic elastomer (a) content of 30% by weight (inclusive) to 85% by weight (inclusive).
(9) The flexographic printing plate described in item (8) above, wherein the photosensitive resin composition has a thermoplastic elastomer (a) content of 50% by weight (inclusive) to 85% by weight (inclusive).
(10) The flexographic printing plate described in any of items (1) to (9) above, wherein the thermoplastic elastomer (a) has a vinyl aromatic hydrocarbon content of 13% by weight (inclusive) to 35% by weight (inclusive).
(11) The flexographic printing plate described in any of items (1) to (10) above, wherein the photosensitive resin composition is soluble in an organic solvent for development.
(12) The flexographic printing plate described in any of items (1) to (11) above, wherein the photocured product has a Shore A hardness of 50° (inclusive) to 68° (inclusive).
(13) The flexographic printing plate described in any of items (1) to (12) above, further comprising a support, wherein the photocured product is formed on the surface of the support.
(14) A photosensitive resin composition for obtaining the photocured product constituting the flexographic printing plate described in any of items (1) to (12). Advantages of the Invention

According to the present invention, printed matter can be obtained which has little printing density unevenness in halftone dots and the like in flexographic printing.

### Best Mode for Carrying Out the Invention

A preferred form of the present invention is described below.
The printing plate of the present invention comprises a photocured product having a loss tangent (tan δ) of 0.3 or more at 500 Hz in dynamic viscoelastometry using a nonresonance forced vibration apparatus. The technical significance of the loss tangent (tan δ) being 0.3 or more at 500 Hz is described below.

A flexographic printing plate contacts a substrate to be printed on a printing press to transfer inks to the substrate to be printed. Thus, density unevenness may occur, because the area of image portions such as halftone dots does not become constant, in the cases where: the printing press has low mechanical precision and thereby generates oscillation; the substrate to be printed has low thickness precision; and the cushion foam applied over the reverse face of the flexographic printing plate has insufficient cushioning properties.
Shore A hardness is often used as a physical property specifying a printing plate. Studies by the present inventors showed that the printing density unevenness differed even between printing plates having comparable Shore A hardness. Accordingly, the inventors considered that the evaluation of Shore A hardness alone was not enough to improve the printing density unevenness. Then, the present inventors regarded the oscillation of the printing plate during printing as being in the speed region of 100 to 1,000 Hz and have made studies by focusing attention on tan 5 values at 500 Hz in place of the Shore A hardness which is a static characteristic. As a result, it has been found that a particular range of the tan δ value of the printing plate at 500 Hz has the effect of suppressing the printing density unevenness. Specifically, a photo (ultraviolet light)-cured product of a photosensitive resin composition was measured for dynamic viscoelasticity using a nonresonance forced vibration apparatus. When printing was carried out using a flexographic printing plate containing a photocured product having a loss tangent (tan δ) defined by the ratio of loss elastic modulus (E") to storage elastic modulus (E') of 0.3 (inclusive) to 5 (inclusive) at 500 Hz, the surprising result was obtained that printing density unevenness (inconsistency in density) in dot portions could be suppressed. The tan δ value at 500 Hz is 0.3 or more in view of printing density unevenness. The upper limit thereof is not particularly limited; however, the value is preferably 5 or less in view of elasticity as a printing plate. Preferred is 0.55 (inclusive) to 3 (inclusive), more preferably 0.7 (inclusive) to 1.5 (inclusive).

The value of the storage elastic modulus (E') of the photocured product of the photosensitive resin composition for a printing plate at 500 Hz is preferably 12 N/m² or less in view of flexibility when the composition is formed into a printing plate and is preferably 1 N/m² or more, more preferably 1.5 N/m² (inclusive) to 10 N/m² (inclusive) in view of suppressing the deformation of the halftone dots and characters on a printing plate and obtaining fine printed matter.
When the dynamic viscoelasticity of a common photosensitive resin for flexographic printing is measured by temperature sweep in the temperature measurement range of -150°C to 60°C at a frequency of 1 Hz with a tension-type geometry using a nonresonance forced vibration apparatus, the temperature at the tan δ peak value ranges from -100°C (inclusive) to 30°C (inclusive) with the peak value falling within the range of 0.6 to 3.0. However, the temperature at the tan δ peak value not necessarily represents the oscillation speed region of the printing plate although obeying the temperature-time conversion rule; the tanδ peak value itself also does not represent the loss tangent in the oscillation speed region of the printing plate. Thus, for the correlation with the printing density unevenness, the tan δ value at 500 Hz is important rather than the tan δ peak value.
It is difficult to directly determine the tan δ value at 500 Hz by dynamic viscoelastometry. However, the temperature can be decreased from 30°C to -60°C in 10°C decrement in the measurement frequency range of 0.01 Hz to 15.915 Hz at a strain amplitude of 0.1 % to measure the loss elastic modulus (E"), storage elastic modulus (E') and tan δ value every 10°C, followed by preparing a master curve at the reference temperature of 20°C according to the temperature-time conversion rule to calculate the tan δ value at 500 Hz. The detailed conditions will be described in the Evaluation Method in Examples.

The printing plate of the present invention contacts with a substrate to be printed on a printing press. However, if the printing plate is too soft, it is difficult to obtain fine printed matter because of its deformation by compression, while if it is too hard, it is difficult to achieve printed matter having a uniform solid surface.
From this, a photocured product 2.5 mm in thickness configuring the printing plate preferably has a Shore A hardness of 50° (inclusive) to 68° (inclusive), more preferably 55° (inclusive) to 68° (inclusive), further more preferably 60° (inclusive) to 68° (inclusive).
The resultant flexographic printing plate preferably has a surface tension of 36 mN/m or less, more preferably 34 mN/m or less, further more preferably 33 mN/m in view of the surface stain of the printing plate by inks and the density unevenness in dot portions.

The printing plate of the present invention is obtained by photocuring a photosensitive resin composition comprising a thermoplastic elastomer (a), a photopolymerizable unsaturated monomer (b) and a photopolymerization initiator (c). Here, the "photocuring" refers to curing the photosensitive resin composition using an active light source such as a high-pressure mercury-vapor lamp, an ultraviolet fluorescent lamp, a carbon-arc lamp, a xenon lamp, a zirconium lamp and sunlight; the photocured product means a product obtained by photocuring.

The thermoplastic elastomer (a) refers to a high polymer which can be plasticized and molded at high temperature and exhibits properties as a rubber elastomer at ordinary temperature. The thermoplastic elastomer (a) preferably comprises at least one polymer block composed mainly of vinyl aromatic hydrocarbon units (hereinafter simply referred to as vinyl aromatic hydrocarbons) and at least one polymer block composed mainly of conjugated diene units (hereinafter simply referred to as conjugated dienes). As used herein, the term "composed mainly of" refers to containing 50% by weight or more of the respective units in a polymer block.
Examples of the vinyl aromatic hydrocarbon include monomers such as styrene, p-methylstyrene, tertiary-butylstyrene, α-methylstyrene, 1,1-diphenylethylene and vinyltoluene; particularly preferred is styrene. These monomers may be used alone or in a combination of two or more thereof.
Examples of the conjugated diene include butadiene and isoprene; particularly preferred is butadiene in view of abrasion resistance. These monomers may be used alone or in a combination of two or more thereof. To further improve solvent resistance, the double bonds in the conjugated diene may be hydrogenated as needed. In view of the micro image-forming property and chipping resistance of the printing plate, 80 mole% or less of the total amount of the double bonds of the conjugated diene segment is preferably hydrogenated which is contained in the polymer block composed mainly of conjugated dienes. The hydrogenation ratio is more preferably 50 mole% or less, still more preferably 30 mole% or less.

The polymer block composed mainly of conjugated dienes in the thermoplastic elastomer (a) preferably has a side chain group content of 80 mole% or less in view of production cost and the cold flow resistance of the raw printing plate. The content is preferably 35 mole% or more, more preferably 35 to 70 mole%, still more preferably 45 to 70 mole% in view of the chipping resistance and image-forming property of the printing plate and the tan δ value of the photocured product of the photosensitive resin composition for the printing plate. The side chain group content of the polymer block composed mainly of conjugated dienes refers to the content of conjugated dienes having 1,2-bonding and 3,4-bonding and hydrogenated products thereof based on the total amount of conjugated dienes and hydrogenated products thereof.
The hydrogenation ratio and side chain group content can be measured using a nuclear magnetic resonance apparatus (NMR) as described later.

When the polymer block composed mainly of conjugated dienes is, for example, a vinyl aromatic hydrocarbon-butadiene copolymer, the vinyl aromatic hydrocarbon may be distributed uniformly or ununiformly (e.g., in a tapered form) in the copolymer block. Pluralities of the uniformly distributed portions and/or the ununiformly distributed portions may coexist. These polymers may be used alone or in a combination of two or more thereof.
The content of the vinyl aromatic hydrocarbons in the thermoplastic elastomer (a) is preferably 35% by weight or less in view of the hardness and ester solvent resistance of the printing plate and is preferably 13% by weight or more in view of the cold flow resistance of the raw printing plate. More preferable is 15 to 30% by weight.

The content of the thermoplastic elastomer (a) in the photosensitive resin composition is preferably 30% by weight or more in view of the ester solvent resistance and chipping resistance of the printing plate and is preferably 85% by weight or less in view of the flexibility of the printing plate and the tan δ value at 500 Hz of the photocured product of the photosensitive resin composition for the printing plate. More preferable is 40% by weight to 85% by weight. Still more preferable is 50% by weight to 85% by weight. Although the content of the thermoplastic elastomer (a) in the photosensitive resin composition is determined by the raw material composition ratio before the production of the photosensitive resin composition, it can also be calculated for the produced photosensitive resin composition by separation thereof using gel permeation chromatography (GPC).
The GPC apparatus used was LC-10 (manufactured by Shimadzu Corporation, trade name). The measurement was performed at an oven temperature of 40°C using two TSKgel GMHXL (trademark) columns (4.6 mm IDx30 cm) manufactured by Tosoh Corporation, and tetrahydrofuran (1.0 ml/min.) as an eluent. A fraction having a specific range of molecular weight in the photosensitive resin composition can be separated by preparing a calibration curve using a polystyrene preparation whose molecular weight is known. In this respect, tetrahydrofuran was used as a solvent for the polystyrene preparation and photosensitive resin composition. The content of the thermoplastic elastomer (a) in the produced photosensitive resin composition can be calculated by separating and purifying a fraction having a number average molecular weight of 80,000 or more and dividing the weight of the resultant purified product by the weight of the charged sample from the photosensitive resin composition.

Examples of the block copolymer for the thermoplastic elastomer (a) include straight-chain block copolymers of general formula group (I) below:

(A-B)n, A-(B-A)ₙ, A-(B-A)ₙ-B, B-(A-B)ₙ (I)

or straight-chain block copolymers or radial block copolymers of general formula group (II) below:

[(A-B)ₖ]ₘ-X, [(A-B)ₖ-A]ₘ-X, [(B-A)ₖ]ₘ-X, [(B-A)ₖ-B]ₘ-X (II).

In the above formulas, A represents, for example, a polymer block composed mainly of a vinyl aromatic hydrocarbon; B represents, for example, a conjugated diene polymer block composed mainly of butadiene and/or isoprene; X represents, for example, the residue of a coupling agent such as silicon tetrachloride, tin tetrachloride, epoxidized soybean oil, a polyhalogenated hydrocarbon compound, a carboxylate ester compound, a polyvinyl compound, a bisphenol-type epoxy compound, an alkoxysilane compound, a halogenated silane compound and an ester-based compound, or the residue of an initiator such as a polyfunctional organolithium compound; and n, k and m each represent an integer of 1 or more, for example, 1 to 5.
The structures represented by the above formulas can be arbitrarily combined with each other. These thermoplastic elastomers (a) may be used alone or in a combination of two or more thereof. When at least one thermoplastic elastomer in which B is a polymer block composed mainly of butadiene (a-Bd) and at least one thermoplastic elastomer in which B is a polymer block composed mainly of isoprene (a-Ip) are used for the combination of two or more, the weight ratio of (a-Bd)/(a-Ip) in the total amount of the thermoplastic elastomers is preferably 1 or more in view of abrasion resistance. More preferable is 1.5 or more. Still more preferable is 2.5 or more.
According to the present invention, among the straight-chain block copolymers represented by formulas (I) and the structures represented by formulas (II), the block copolymer having an m of 4 or less is preferable in view of the performance balance of the composition obtainable, productivity, and the shape stability of the resulting plate.
For the total weight (ii) of the straight-chain block copolymers or radial block copolymers represented by general formulas (II) and the total weight (i) of straight-chain block copolymers represented by general formulas (I) in the thermoplastic elastomer (a), the weight ratio of (i), that is, (i)/(i)+(ii), is preferably 0.4 or less in view of the cold flow resistance of the raw printing plate and the chipping resistance of the printing plate and is preferably 0.1 or more in view of the flexibility of the printing plate and the tan δ value of the photocured product of the photosensitive resin composition for the printing plate at 500 Hz. More preferable is 0.15 to 0.3.
The thermoplastic elastomer (a) may be used, as needed, in combination with the completely hydrogenated product of a conjugated diene: styrene-ethylenebutylene block copolymer, styrene-ethylene-propylene block copolymer, or the like in such a range that the object of the present invention is not impaired.
The molecular weight of the thermoplastic elastomer (a) is not particularly limited, but is preferably that capable of providing the excellent balance between the moldability and the solidity-keeping property of the photosensitive resin composition obtainable. The number average molecular weight is preferably 80,000 to 500,000. Here, the number average molecular weight is obtained by measurement using gel permeation chromatography (GPC), followed by conversion from a polystyrene preparation whose molecular weight is known.

Examples of the photopolymerizable unsaturated monomer (b) include esters of acrylic acid, methacrylic acid, fumaric acid, maleic acid and the like; derivatives of acrylamide and methacrylamide; allylic esters, styrene, and derivatives thereof; and N-substituted maleimide compounds. Specific examples thereof can include diacrylates and dimethacrylates of alkane diols such as hexane diol and nonane diol, or diacrylates and dimethacrylates of ethylene glycol, diethylene glycol, propylene glycol, dipropylene glycol, polyethylene glycol and butylene glycol; trimethylolpropane tri(meth)acrylate; dimethyloltricyclodecane di(meth)acrylate; isoboronyl (meth)acrylate; phenoxypolyethylene glycol (meth)acrylate; pentaerythritol tetra(meth)acrylate; N,N'-hexamethylenebisacrylamide and N,N'-hexamethylenebismethacrylamide; styrene; vinyltoluene; divinylbenzene; diacryl phthalate; triallyl cyanurate; diethyl fumarate; dibutyl fumarate; dioctyl fumarate; distearyl fumarate; butyloctyl fumarate; diphenyl fumarate; dibenzyl fumarate; dibutyl maleate; dioctyl maleate; bis(3-phenylpropyl) fumarate; dilauryl fumarate; dibehenyl fumarate; and N-laurylmaleimide. These monomers may be used alone or in a combination of two or more thereof.
The higher glass transition temperature (Tg) of a polymer of a photopolymerizable unsaturated monomer alone tends to increase the tan δ value of the photocured product of the photosensitive resin composition for the printing plate at 500 Hz. Here, the glass transition temperature (Tg) can be measured by differential scanning calorimetry (DSC).
The content of the photopolymerizable unsaturated monomer (b) in the photosensitive resin composition is preferably 0.5% by weight or more in view of properties forming fine dots and characters and is preferably 30% by weight or less in view of the cold flow resistance when the raw printing plate before exposure is laminated and the flexibility of the printing plate. More preferable is 1 to 15% by weight.

As used herein, the photopolymerization initiator (c) refers to a compound which absorbs the energy of light and generates radicals; various known compounds may each be used as the initiator. Preferred are various organic carbonyl compounds, particularly aromatic carbonyl compounds. Specific examples thereof include benzophenone, 4,4-bis(diethylamino)benzophenone, t-butylanthraquinone, 2-ethylanthraquinone, thioxanthones such as 2,4-diethylthioxanthone, isopropylthioxanthone and 2,4-dichlorothioxanthone; acetophenones such as diethoxyacetophenone, 2-hydroxy-2-methyl-1-phenylpropan-1-one, benzyldimethylketal, 1-hydroxycyclohexyl-phenylketone, 2-methyl-2-morpholino(4-thiomethylphenyl)propan-1-one and 2-benzyl-2-dimethylamino-1-(4-morpholinophenyl)-butanone; benzoin ethers such as benzoin methyl ether, benzoin ethyl ether, benzoin isopropyl ether and benzoin isobutyl ether; acylphosphine oxides such as 2,4,6-trimethylbenzoyldiphenylphosphine oxide, bis(2,6-dimethoxybenzoyl)-2,4,4-trimethylpentylphosphine oxide and bis(2,4,6-trimethylbenzoyl)-phenylphosphine oxide; methylbenzoylformate; 1,7-bisacridinylheptane; and 9-phenylacridine. These compounds may be used alone or in a combination of two or more thereof.
The content of the photopolymerization initiator (c) in the photosensitive resin composition is preferably 0.1% by weight or more in view of properties forming fine dots and characters as a printing plate and is preferably 10% by weight or less in view of the active light (e.g., ultraviolet light) transmittance of the raw printing plate. More preferable is 0.5 to 5% by weight.

The photosensitive resin composition may optionally contain a particulate polymer which is solid at ordinary temperature and can be dissolved or swollen in water or an organic solvent such as a radical copolymer, a polyamide polymer, a polyvinyl alcohol polymer, a polyester polymer, a polyurethane copolymer and a conjugated diene polymer, .
The radical copolymer capable of being dissolved or swollen in water is obtained, for example, by copolymerization using 100 parts by weight of unsaturated monomers including 1 part by weight or more of a hydrophilic unsaturated monomer. Examples of the hydrophilic unsaturated monomer include an acidic functional group- containing unsaturated monomer such as an ethylenically unsaturated monomer having a carboxyl group, a sulfonic acid group, a phosphoric acid group, a boric acid group or a hydroxyl group.
The content of the particulate polymer in the photosensitive resin composition is preferably 40% by weight or less, more preferably 30% by weight or less, still more preferably 20% by weight or less in view of suppressing defects including the lowering of physical properties and chipping of the printing plate.

The photosensitive resin composition may optionally contain various auxiliary, additional components such as, for example, a plasticizer, a thermopolymerization inhibitor, an ultraviolet absorber, a halation inhibitor, a light stabilizer and a surface treatment.
Examples of the plasticizer include a natural resin such as rosin or terpene; and a synthetic resin such as an aliphatic (C5) resin, an aromatic (C9) resin and an alicyclic resin and hydrogenated resins thereof, for example, a naphthene plasticizer, paraffin oil, an olefin hydrocarbon oil, liquid polybutadiene, liquid polyisoprene, a modified liquid polybutadiene, liquid acrylonitrile-butadiene copolymer, liquid styrene-butadiene copolymer, a polystyrene with a number average molecular weight of 2,000 or less, a sebacic acid ester, or a phthalate ester. These components may contain photopolymerizable reactive groups.
Among these plasticizers, a plasticizer having a glass transition temperature (Tg) of -30°C or higher is preferable to increase the tan δ value of the photocured product of the photosensitive resin composition for the printing plate at 500 Hz. The Tg of the plasticizer is more preferably 0°C or higher, still more preferably 15°C or higher, most preferably 20°C or higher. Here, the glass transition temperature can be measured by differential scanning calorimetry (DSC).
These plasticizers include, for example, "ARCON P-70" (manufactured by Arakawa Chemical Industries, Ltd., trademark, a hydrogenated C9 petroleum resin, Tg: 20°C), "CLEARON P-85" (manufactured by Yasuhara Chemical Co., Ltd., trademark, a hydrogenated terpene resin, Tg: 30°C), "ARCON M-90" (manufactured by Arakawa Chemical Industries, Ltd., trademark, a hydrogenated C9 petroleum resin, Tg: 40°C), and "ESCOREZ-5380" (manufactured by Exxon Mobil Corporation, trademark, a dicyclopentadiene, Tg: 30°C).
The content of such a plasticizer with a high Tg is preferably 25% by weight or less in view of the chipping resistance of the printing plate and is preferably 5% by weight or more in view of the tan δ value of the photocured product of the photosensitive resin composition for the printing plate at 500 Hz. More preferable is 7 to 20% by weight.
The molecular weight of the plasticizer is not particularly limited; however, preferred is a plasticizer excellent in compatibility with the thermoplastic elastomer (a) and the solidity-keeping property of the photosensitive resin composition obtainable. The preferred range of the number average molecular weight is 2,000 or less for a plasticizer with a high Tg and 1,000 to 50,000, more preferably 3,000 to 20,000 for liquid polybutadiene, liquid polyisoprene and a modified liquid polybutadiene. Here, the number average molecular weight is obtained by measurement using gel permeation chromatography(GPC), followed by conversion from a polystyrene preparation whose molecular weight is known.
The above plasticizers may be used alone or in a combination of two or more thereof. Preferred is the combined use of a plasticizer with a high Tg and liquid polybutadiene or a modified liquid polybutadiene in view of forming micro images.

The photosensitive resin composition of the present invention may be that capable of being dissolved in an organic solvent for development or in an aqueous developing solution. Preferred is a photosensitive resin composition capable of being dissolved in an organic solvent for development in view of the physical properties and abrasion resistance of the flexographic printing plate. The tan δ of the photocured product of the photosensitive resin composition for the printing plate at 500 Hz is also influenced by the content of the thermoplastic elastomer (a) in the photosensitive resin composition, the type of the plasticizer, and the like. Particularly, the photosensitive composition capable of being dissolved in the organic solvent has a high proportion of the plasticizer and thermoplastic elastomer in the photosensitive composition compared to a water-soluble photosensitive composition containing a large amount of a hydrophilic copolymer, which makes markedly large the effect by controlling the content of the thermoplastic elastomer (a) in the photosensitive resin composition, the type of the plasticizer, and the like. Thus, use of the photosensitive resin composition capable of being dissolved in an organic solvent for development allows the effect of the present invention to be more exerted than the water-soluble photosensitive resin composition. In addition, the printing plate obtained from the photosensitive composition capable of being dissolved in an organic solvent has low surface tension and can have improved printing density unevenness compared to the printing plate obtained from the water-soluble photosensitive resin composition.

The raw plate for flexographic printing according to the present invention can be produced by various methods. By way of example, raw materials for the photosensitive resin composition can be dissolved and mixed in a solvent such as, for example, chloroform, tetrachloroethylene, methyl ethyl ketone and toluene, which is then cast into a mold and subjected to the evaporation of the solvent to directly make into a plate form. The raw materials can also be kneaded in a kneader, a roll mill, or a screw extruder without using any solvent, followed by molding into a desired thickness employing a calender roll, a press, or the like. However, the present invention is not intended to be limited to these production methods.

Photosensitive resin compositions generally have tackiness. Therefore, a thin flexible protection layer soluble in an organic solvent or aqueous developing solution (Japanese Patent Publication No. 05-13305) may be provided on the resin layer surface to make good the contact with a negative film overlapped thereon in plate-making or to enable the reuse of the negative film. The flexible protection layer may also be set to an ultraviolet blocking layer containing an infrared-sensitive substance to use the flexible layer itself as a negative by direct drawing with an infrared laser. In each case, when unexposed portions are washed out after the end of exposure, the thin flexible protection layer is simultaneously removed. The flexible protection layer may also contain a delusterant such as silica.

When a solvent-soluble thin flexible protection layer, e.g., a layer of a washing-out liquid-soluble compound such as polyamide, partially saponified polyvinyl acetate and cellulose ester, or a layer of polyvinyl alcohol and the like, capable of being developed with an aqueous developing solution, is provided on the surface of the photosensitive resin layer, these protection layers and the layer capable of being developed with an aqueous developing solution may each be dissolved in a suitable solvent or water, followed by directly coating the solution on the photosensitive resin layer. Alternatively, the solution may be coated on a film such as polyester and polypropylene (protection film), followed by laminating or press-bonding the protection film on the photosensitive layer to transfer the protective coat.

The support may use a known support such as, for example, a polyester film, a polyamide sheet and a metal plate. Preferably, a dimensionally stable polyester film having a thickness ranging from 75 to 300 µm may be used; examples of the polyester film can include all aromatic polyester films such as a polyethylene terephthalate film, a polybutylene terephthalate film and a polyethylene naphthalate film. In addition, to secure the adhesive force between the support and the photosensitive resin composition, a known adhesive may be applied which is described, for example, in Japanese Patent Laid-Open No. 2000-155410 or 2001-264959.
Generally, the protection film and support can be allowed to adhere to an extrusion-molded photosensitive resin composition by roll-lamination to provide a raw printing plate.

A flexographic printing plate can be produced from the raw plate for flexographic printing, for example, by the following method. The whole surface of the raw printing plate is first subjected to ultraviolet exposure (back exposure) through the support to provide a thin uniform cured layer thereon. The surface of the photosensitive resin layer is then subjected to image exposure (relief exposure) indirectly through a negative film or directly from above the ultraviolet blocking layer. Subsequently, unexposed portions are removed by any of methods including (i) a method involving washing with an organic solvent for development, water, or an aqueous developing solution containing water and a surfactant, (ii) a method involving heating at 40 to 200°C to allow an absorbing layer to absorb, and (iii) a method involving applying shearing force with gas or fluid. If necessary, drying treatment and, further, post-exposure is carried out to provide a printing plate.
Either exposure (relief exposure) from the negative film side or exposure (back exposure) from the support side may be earlier performed, and both of the exposures may also be simultaneously carried out.
Examples of the exposure light source include a high pressure mercury lamp, an ultraviolet fluorescent lamp, a carbon arc lamp, a xenon lamp, a zirconium lamp, and sunlight.
Examples of the organic solvent used for development of the unexposured portions include a mixture of an alcohol such as propanol, butanol and pentanol with an ester such as heptyl acetate and 3-methoxybutyl acetate, a hydrocarbon such as petroleum fraction, toluene and decalin, or a chlorine-based organic solvent such as tetrachloroethylene.
The aqueous developing solution used for development of the unexposured portions may contain at least one of nonionic, anionic, cationic and ampholytic surfactants.

Specific examples of the anionic surfactant include a straight-chain alkylbenzene sulfonate having 8 to 16 carbons on the average, an α-olefin sulfonate having 10 to 20 carbons on the average, a dialkylsulfosuccinate having an alkyl or alkenyl group having 4 to 10 carbons, a fatty acid lower alkyl ester sulfonate, an alkylsulfate having 10 to 20 carbons on the average, an alkyl ether sulfate which contains a straight-chain or branched alkyl or alkenyl group having 10 to 20 carbons on the average and has an average 0.5 to 8 moles of ethylene oxide added, and a saturated or unsaturated fatty acid salt having 10 to 22 carbons on the average.
Specific examples of the cationic surfactant include an alkylamine salt, an alkylamine ethylene oxide adduct, an alkyltrimethylammonium salt, an alkyldimethylbenzylammonium salt, a Sapamine-type quaternary ammonium salt, and a pyridium salt.
Specific examples of the nonionic surfactant include a polyethylene glycol-type higher alcohol alkylene oxide adduct, an alkylphenol alkylene oxide adduct, a fatty acid alkylene oxide adduct, a polyhydric alcohol fatty acid ester alkylene oxide adduct, a higher alkylamine alkylene oxide adduct, a fatty acid amide alkylene oxide adduct, an alkylene oxide adduct of fat and oil, a polypropylene glycol alkylene oxide adduct, a polyhydric alcohol-type glycerol fatty acid ester, a pentaerythritol fatty acid ester, a fatty acid ester of sorbitol and sorbitan, a sucrose fatty acid ester, a polyhydric alcohol alkyl ether, and a fatty acid amide of an alkanolamine.
Specific examples of the ampholytic surfactant include sodium laurylaminopropionate and lauryldimethylbetaine.
The surfactant concentration is not particularly limited; however, the surfactant is typically used in the range of 0.5 to 10% by weight based on the total amount of the developing solution.

In addition to the above surfactant, developing assistants such as a washing accelerator and a pH adjuster may be blended in the developing solution. Examples of the washing accelerator include an amine such as monoethanolamine, diethanolamine and triethanolamine, a glycol ether, an ammonium salt such as tetramethylammonium hydroxide, and a paraffin hydrocarbon. Examples of the pH adjuster include sodium borate, sodium carbonate, sodium silicate, sodium metasilicate, sodium succinate, and sodium acetate. The developing assistants may be used alone or in a combination of two or more thereof. The developing assistant preferably has a boiling point of 130°C or higher at ordinary pressure. The developing assistant having a boiling point of less than 130°C tends to evaporate and remove a considerable amount of the developing assistant together with water when water is evaporated from the developing solution to recover the assistant as a condensate. Or, when the developing assistant is used for the purpose of the concentration adjustment of the developing solution, labor is involved which includes that the amount of the entrained solvent must be measured and adjusted to make the performance of the developing solution stable.
The developing solution may contain an anti-foaming agent, a dispersant, a corrosion inhibitor and a preservative, as needed.
The unexposured portion is typically washed out by jetting from a nozzle or brushing with a brush.
The plate developed with an organic solvent or an aqueous developing solution is subjected to drying treatment, as needed. For example, the plate can be dried at about 60°C in an oven for 15 to 120 minutes. After drying, it is subjected to post-exposure, as needed. Examples of the post-exposure include a method involving irradiating the plate with light of a wavelength of 300 nm or less and/or light of a wavelength of more than 300 nm.
Before printing, the printing plate of the present invention may be subjected to the surface treatment thereof with a solution containing silicon oil, a hydrocarbon or the like, having low surface tension, to suppress the staining of the printing plate surface by ink.

### Examples

The present invention is specifically described below by way of Examples and Comparative Examples. However, the invention is not intended to be limited to these Examples. In addition, methods for measuring physical properties in Examples and Comparative Examples are as follows.
(1) Styrene Content
   The content of styrene was calculated from absorption intensity at 262 nm using the ultraviolet spectrophotometer "UV200" (manufactured by Hitachi, Ltd., trademark).
(2) Side Chain Group Content (Amount of 1,2-Vinyl Bonds)
   The side chain group content was measured using the nuclear magnetic resonance apparatus (1H-NMR) "JNM-LA400" (manufactured by JEOL, trademark). Here, deuterated chloroform was used as a solvent to adjust the concentration of a thermoplastic elastomer (a) to 50 mg/ml. Using TMS (tetramethylsilane) as a chemical shift reference, the measurement was carried out at an observing frequency of 400 MHz under conditions of a pulse delay of 2.904 seconds, a scan number of 64, a pulse width of 45° and a measurement temperature of 26°C. The side chain group content (V) (%) was determined according to the equation: α/(α+β)×100 where (α) is the signal area at approximately 5.0 ppm derived from a 1,2-vinyl bond structure; (β) is the signal area at approximately 5.4 ppm derived from a 1,4-vinyl bond structure.
(3) Hydrogenation Ratio
   The hydrogenation ratio was measured using a nuclear magnetic resonance apparatus (1H-NMR). The measurement was carried out under the same conditions as those for the calculation of the amount of 1,2-vinyl bonds. The hydrogenation ratio was determined from the signal areas of methyl and methylene groups and the like derived from a hydrogenated structure.

### Examples 1 to 7 and Comparative Examples 1 and 2

### (1) Synthesis of Thermoplastic Elastomer (a-1)

A 10-L stainless reaction vessel equipped with a jacket and a stirrer was sufficiently purged with nitrogen. Then, 6,500 g of cyclohexane, 1.2 g of tetrahydrofuran, 4.5 g of N,N,N',N'-tetramethylethylenediamine, and 180 g of styrene were charged into the reaction vessel. The contents were set at approximately 55°C by circulating hot water through the jacket. Then, the polymerization of styrene was initiated by the addition of a cyclohexane solution of n-butyllithium (1.25 g in pure content). Three minutes after styrene was almost completely polymerized, 820 g of butadiene (1,3-butadiene) was added thereto to continue polymerization. Four minutes after butadiene was almost completely polymerized, 0.9 g of tetramethoxysilane was added as a coupling agent thereto to perform coupling reaction. The system was continuously stirred with a stirrer during the period from immediately after charging styrene to the end of the coupling reaction. A part of the resultant block copolymer solution was sampled. Then, the solvent was removed from the sample by heating. The styrene content and the amount of 1,2-vinyl bonds (side chain group content) in the polybutadiene portion were measured using the block copolymer solution. As a result, the styrene content of the resultant block copolymer was 18% by weight, and the amount of 1,2-vinyl bonds in the polybutadiene portion was 66 mole%.
Next, the remaining block copolymer solution was used to perform hydrogenation at a temperature of 70°C with biscyclopentadienyl titanium chloride and n-butyllithium as hydrogenation catalysts. The hydrogenation ratio was controlled by measuring the amount of hydrogen gas supplied with a flow meter and terminating gas supply at the time when the target hydrogenation ratio was achieved. Then, 10 g of water was added thereto. After stirring, 3.0 g of n-octadecyl-3-(3',5'-di-tert-butyl-4'-hydroxyphenyl) propionate, 1.5 g of 2,4-bis(n-octylthiomethyl)-o-cresol were added thereto. The solvent was removed from the resultant solution by steam stripping to provide a hydrous crumb. Subsequently, the crumb was dehydrated and dried with a heat roll to provide a sample of a thermoplastic elastomer (a-1) having a hydrogenation ratio of 20 mole%.

### (2) Synthesis of Thermoplastic Elastomer (a-2)

A 10-L stainless reaction vessel equipped with a jacket and a stirrer was sufficiently purged with nitrogen. Then, 6,500 g of cyclohexane, 1.2 g of tetrahydrofuran, 2.3 g of N,N,N',N'-tetramethylethylenediamine, and 180 g of styrene were charged into the reaction vessel. The contents were set at approximately 55°C by circulating hot water through the jacket. Then, the polymerization of styrene was initiated by the addition of a cyclohexane solution of n-butyllithium (1.25 g in pure content). Three minutes after styrene was almost completely polymerized, 820 g of butadiene (1,3-butadiene) was added thereto to continue polymerization. Four minutes after butadiene was almost completely polymerized, 0.9 g of tetramethoxysilane was added as a coupling agent thereto to perform coupling reaction. The system was continuously stirred with a stirrer during the period from immediately after charging styrene to the end of the coupling reaction. A part of the resultant block copolymer solution was sampled. Then, the solvent was removed from the sample by heating.
The resultant thermoplastic elastomer (a-2) had a styrene content of 18% by weight and a 1,2-vinyl bond amount of 50 mole% in the polybutadiene portion.

### (3) Synthesis of Thermoplastic Elastomers (a-3) and (a-4)

Thermoplastic elastomers (a-3) and (a-4) were obtained in the same way as in the synthesis of the thermoplastic elastomer (a-2) except that the temperature of the jacket hot water during polymerization was changed to 70°C and the amount of N,N,N',N'-tetramethylethylenediamine was varied to 1.2 g (for the thermoplastic elastomer (a-3)) and 0.9 g (for the thermoplastic elastomer (a-4)). The thermoplastic elastomer (a-3) had a styrene content of 18% by weight and a 1,2-vinyl bond amount of 45 mole% in the polybutadiene portion. The thermoplastic elastomer (a-4) had a styrene content of 18% by weight and a 1,2-vinyl bond amount of 40 mole% in the polybutadiene portion.

### (4) Synthesis of Thermoplastic Elastomer (a-5)

Thermoplastic elastomer (a-5) was obtained in the same way as in the synthesis of the thermoplastic elastomer (a-1) except that the temperature of the jacket hot water during polymerization was changed to 70°C, the amount of N,N,N',N'-tetramethylethylenediamine was varied to 0.9 g, and the amount of hydrogen gas supplied is changed. The resultant thermoplastic elastomer (a-5) had a styrene content of 18% by weight, a 1,2-vinyl bond amount of 40 mole% in the polybutadiene portion before hydrogenation, and a hydrogenation ratio of 20 mole%.

### (5) Preparation of Photosensitive Resin Composition, Raw Plate for Flexographic Printing, and Flexographic Printing Plate

### (5-1) Preparation of Photosensitive Resin Composition

Components shown in each of Examples 1 to 7 and Comparative Examples 1 and 2 in Table 1 were blended in a kneader at 140°C for 60 minutes to provide a photosensitive resin composition.

### (5-2) Preparation of Raw Plate for Flexographic Printing

The resultant photosensitive resin composition was sandwiched between a polyester film support 125 µm in thickness coated with a thermoplastic elastomer-containing adhesive and a 100-µm in thickness polyester coversheet having a polyamide layer 4 µm in thickness, and pressed using a 2.5-mm in thickness spacer at a pressure of 200 kg/cm² over a period of 4 minutes under conditions of 130°C to mold a raw plate for flexographic printing.

### (5-3) Preparation of Flexographic Printing Plate

The coversheet was then peeled off from the raw plate for flexographic printing. A negative film was brought into tight contact with the protection layer of polyamide provided on the photosensitive resin layer. Exposure on the whole surface was first effected from the support side using an ultraviolet fluorescent lamp having a center wavelength of 370 nm on the exposing machine "AFP-1500" (manufactured by Asahi Kasei Chemicals Corp., trademark) so as to provide a cured layer thickness of 1.8 mm. Subsequently, image (relief) exposure was conducted at 6,000 mJ/cm² through the negative film.
The exposure intensity here was measured using the UV illuminometer MO-2 manufactured by ORC Manufacturing Co., Ltd., which is equipped with the filter UV-35. The measured intensity of the ultraviolet light from a lamp on the lower side for the back exposure on a glass plate was 10.3 mW/cm², whereas the measured intensity of the ultraviolet light from a lamp on the upper side for the relief exposure was 12.5 mW/cm².
Subsequently, the resultant plate was attached with a double-sided adhesive tape onto a rotating cylinder of a developing machine AFP-1500 (manufactured by Asahi Kasei Chemicals Corp., trademark) using 3-methoxybutyl acetate as a developing solution. The plate was subjected to development at a liquid temperature of 25°C for 5 minutes and dried at 60°C for 2 hours. Then, in post-exposure, the whole surface of the plate was exposed at 2,000 mJ/cm² using a germicidal lamp having a center wavelength of 254 nm, and successively exposed at 1,000 mJ/cm² using an ultraviolet fluorescent lamp to provide a flexographic printing plate. In this respect, the post-exposure light amount by the germicidal lamp was calculated from the illuminance measured using the MO-2 machine equipped with a UV-25 filter.

Performance evaluation was then carried out by methods described below. The results obtained are shown in Table 1.

### (a) Dynamic Viscoelasticity

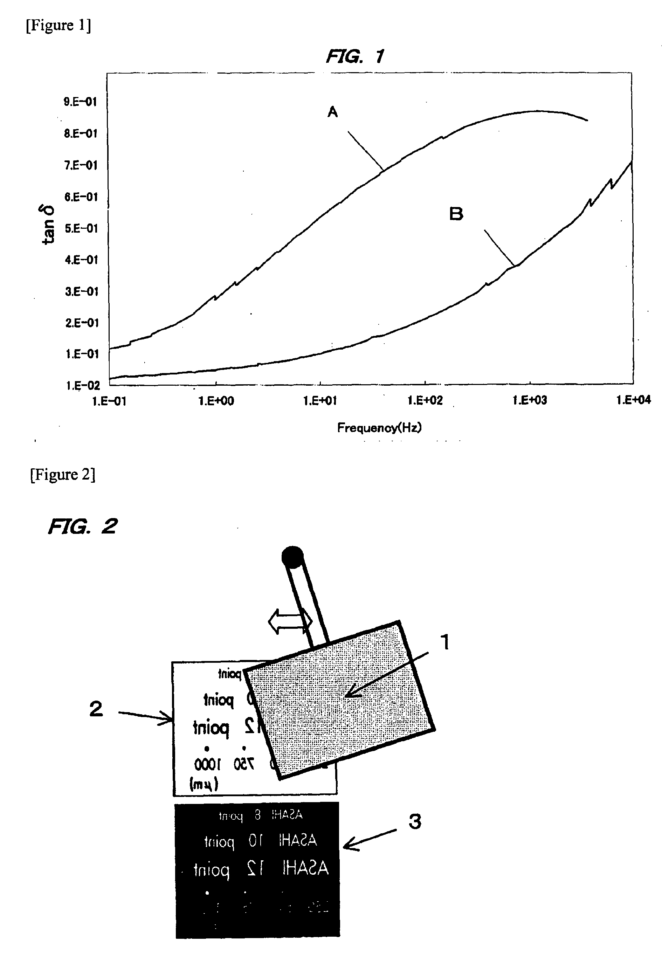

The photosensitive resin composition obtained in the above (5-1) was sandwiched between two 100 µm thick transparent polyester films whose surface was treated with silicon instead of being sandwiched between the support and cover film described in the above (5-2). The composition was then press-molded under the same conditions as in the above (5-2) to provide a photosensitive resin sheet. The resultant photosensitive resin sheet was subjected to whole surface exposure at 3,000 mJ/cm² from both sides using an ultraviolet fluorescent lamp having a center wavelength of 370 nm on the exposing machine "AFP-1216" (manufactured by Asahi Kasei Chemicals Corp., trade name) to provide a photocured product of the photosensitive resin composition. The exposure intensity was measured using a UV luminometer (MO-2, trade name) manufactured by ORC Manufacturing Co., Ltd., which is equipped with the filter UV-35 (manufactured by ORC Manufacturing Co., Ltd., trade name).
The silicon-treated polyester films on both sides were then removed, followed by cutting the photocured product into a size of 10 mm wide and 35 mm long. The resultant sample was set in a tension-type geometry of the apparatus RSA-II (manufactured by Rheometric Scientific F. E. Ltd., trade name), in which the force in the axial direction was adjusted to around 0 N/m², followed by measuring the dynamic viscoelasticity, i.e., the loss elastic modulus (E"), storage elastic modulus (E') and tan δ value, in a frequency/temperature sweep test at an effective measurement length of 22.6 mm and a strain of 0.1%. The actually applied measuring frequency was set to range from 0.01 Hz to 15.915 Hz with a sine wave form. The measurement temperature was reduced from 30°C to -60°C in steps of 10°C. According to an application soft (RSI-Orchestrator version 6.5.1) for the apparatus, a master curve was automatically prepared at the reference temperature of 20°C following the temperature-time conversion rule to read the tan δ value at 500 Hz. The measurement results (graph) in Examples 2 and 5 are shown in Figure 1. In Figure 1, A and B indicate Examples 2 and 5, respectively.

### (b) Shore A Hardness

A flexographic printing plate 2.5 mm in thickness was allowed to stand in a constant temperature and humidity chamber at a temperature of 23°C and a relative humidity of 50% for one day, followed by measurement using the JIS constant-pressure loader GS-710 (manufactured by Teclock Co., Ltd., Durometer GS-719G ASTM: D2240A, JIS: K6253A, ISO: 7619A). The value 15 seconds after loading (mass: 1 kg) on the solid surface was defined as Shore A hardness.

### (c) Surface Tension

The surface tension can be measured using Wetting Tension Test Mixture (manufactured by Wako Pure Chemical Industries Ltd., trademark) under conditions of a temperature of 20°C and a relative humidity of 50%. A solid portion on a printing plate immediately after plate-making was wiped two or three times with a nonwoven fabric containing ethanol to remove stains and dried under predetermined temperature and humidity conditions for 2 days or more. Then, Wetting Tension Test Mixture was instantaneously (within 0.5 second) applied to the solid portion along a length of about 5 cm using a nonwoven fabric 25 mm in width with the Mixture absorbed. The surface tension was determined by visual observation from the tension of Wetting Tension Test Mixture when the Mixture was not repelled 2 seconds after the application.

### (d) Density Unevenness Test for Printed Matter

A printing test was carried out on a printing press using the resultant printing plate 2.5 mm in thickness. The pattern of the negative film used for the preparation of the printing plate had the two rulings of 133 lpi and 150 lpi. With each thereof are printed 20%, 30%, 40%, 50% and 60% (each size: 10 cmx75 cm) halftone dots and 2-point to 8-point Gothic characters. Cushion Tape 1915 (manufactured by 3M Co., Ltd., trade name), which had a thickness of 0.35 mm, was attached to the reverse face of the printing plate. Printing of 10,000 m was performed at a printing speed of 80 m/min. using XS-716 (manufactured by Dainippon Ink and Chemicals, Inc., trade name) as an ester solvent-containing ink, low density polyethylene (0.04 mm in thickness) as a substrate to be printed, and a 800 lpi anilox roll (cell volume: 3.8 cm³/m²). After printing, the dot and character portions of the printed matter were visually observed. A case where printing density unevenness was least, with good printing quality maintained, was rated 4; with the further deteriorated condition of printing density unevenness, the rating was decreased to 3, 2 and 1. In this respect, in all of the printing tests, there was not observed a phenomenon in which solid images became blurred midway through printing.

### (e) Chipping Resistance

The mechanical strength of character portions on the printing plate when the plate was swollen by the solvent ink was evaluated in a model experiment as shown in Figure 2. In Figure 2, 1 represents the substrate to be contacted (size: 8 cmx6 cm, material: cloth, load: 1 kg); 2, the printing plate; and 3, the negative film used when printing plate 2 was made. The pattern of the negative film used for the preparation of the printing plate was that in which characters having a size of 8 to 12 points were printed as shown in Figure 2. The 2.5-mm thick printing plate obtained using the pattern was dipped in a 20% by weight ethyl acetate-isopropyl alcohol solution for 4 hours. Then, the degree of destruction of characters after scrubbing 300 times crosswise using an NP-type printing durability tester (manufactured by Niimura Printing Co., Ltd., trademark, contacting body: cloth, load: 1 kg) was observed with a microscope. The chipping resistance was determined as good when only 8-point characters were destroyed, as fair when 10-point characters were destroyed, and as poor when 12-point characters were also destroyed.

**Table 1**

| (parts by weight) | | | | | | | | | | |
|---|---|---|---|---|---|---|---|---|---|---|
| Components | | Ex.1 | Ex. 2 | Ex. 3 | | Ex. 4 Ex. 5 | Ex. 6 | Ex. 7 | Comp. Ex.1 | Comp. Ex. 2 |
| Thermoplastic elastomers (a) | (a-1) Vinyl before hydrogenation: 66%, Hydrogenation percentage: 20% | 50 | 60 | 60 | 50 | 60 | | | | |
| | (a-2) Vinyl: 50% | | | | | | 60 | | | |
| | (a-3) Vinyl: 45% | | | | | | | 60 | | |
| | (a-4) Vinyl: 40% | | | | | | | | 60 | |
| | (a-5) Vinyl before hydrogenation: 40%, Hydrogenation percentage: 20% | | | | | | | | | 60 |
| Plasticizers | B1000 (manufactured by Nippon Soda Co., Ltd., trademark) Tg-43°C | 21 | 11 | 16 | 41 | 31 | 31 | 31 | 31 | 31 |
| | ARCONP70 (manufactured by Arakawa Chemical Industries, Ltd., trademark) Tg 20°C | 20 | 20 | 15 | | | | | | |
| Monomers (b) | 1,9-nonanediol diacrylate | 7 | 7 | 7 | 7 | 7 | 7 | 7 | 7 | 7 |
| | 1,6-hexanediol dimethacrylate | 2 | 2 | 2 | 2 | 2 | 2 | 2 | 2 | 2 |
| Additives | 2,2-dimethoxy-phenylacetophenone | 2 | 2 | 2 | 2 | 2 | 2 | 2 | 2 | 2 |
| | 2,6-di-t-butyl-p-cresole | 1 | 1 | 1 | 1 | 1 | 1 | 1 | 1 | 1 |
| (a) Tan δ of photocured product at 500 Hz | | 0.93 | 0.82 | 0.67 | 0.55 | 0.45 | 0.34 | 0.30 | 0.21 | 0.20 |
| (b) Shore A hardness (°) of photocured product | | 60 | 61 | 60 | 55 | 60 | 57 | 55 | 55 | 55 |
| (c) Surface tension (mN/m) of photocured product | | 34 | 34 | 34 | 35 | 35 | 35 | 35 | 35 | 35 |
| (d) Density unevenness test of printed matter * 1 | | 4 | 4 | 3 | 3 | 2 | 2 | 2 | 1 | 1 |
| (e) Chipping resistance *2 | | Good | Good | Good | Good | Good | Good | Good | Good | Good |

| | | | | | | | | | | |
|---|---|---|---|---|---|---|---|---|---|---|
| *1: Evaluation results of the density unevenness test of printed matter. Best: 4, Very good: 3, Good: 2, and Poor: 1. *2: Evaluation results of chipping resistance. Only 8-point characters are destroyed: Good, 10-point characters are destroyed: Fair, and 12-point characters are also destroyed: Poor. | | | | | | | | | | |

Table 1 shows that printed matter having little printing density unevenness in halftone dots and the like in flexographic printing and also having good solid quality cannot be achieved without using a flexographic printing plate comprising a photocured product which is obtained by photocuring a photosensitive resin composition comprising (a) a thermoplastic elastomer, (b) a photopolymerizable unsaturated monomer and (c) a photopolymerization initiator and has a loss tangent (tan δ) of 0.3 or more at 500 Hz in the dynamic viscoelastometry using a nonresonance forced vibration apparatus.

### Industrial Applicability

According to the present invention, printed matter can be obtained which has little printing density unevenness in halftone dots and the like and also has good solid quality. Thus, the invention can be suitably used in the field of flexographic printing.

### Brief Description of the Drawings

Figure 1 is a graph showing measurements of dynamic viscoelasticity of the photocured products obtained in Examples 2 and 5; and
Figure 2 is a schematic diagram showing a method for evaluating chipping resistance in Examples 1 to 7 and Comparative Examples 1 and 2.

## Claims

1. A flexographic printing plate comprising a photocured product, wherein the photocured product is obtained by photocuring a photosensitive resin composition comprising a thermoplastic elastomer (a), a photopolymerizable unsaturated monomer (b) and a photopolymerization initiator (c) and has a loss tangent (tan δ) of 0.3 or more at 500 Hz in dynamic viscoelastometry using a nonresonance forced vibration apparatus.

2. The flexographic printing plate according to claim 1, wherein the thermoplastic elastomer (a) comprises at least one polymer block composed mainly of vinyl aromatic hydrocarbons and at least one polymer block composed mainly of conjugated dienes.

3. The flexographic printing plate according to claim 2, wherein the polymer block composed mainly of conjugated dienes has a side chain group content of 35 mole% (inclusive) to 80 mole% (inclusive).

4. The flexographic printing plate according to claim 1, wherein the thermoplastic elastomer (a) comprises at least one polymer block composed mainly of vinyl aromatic hydrocarbons and at least one polymer block composed mainly of butadiene and/or hydrogenated butadiene.

5. The flexographic printing plate according to claim 4, wherein the polymer block composed mainly of butadiene and/or hydrogenated butadiene has a side chain group content of 35 mole% (inclusive) to 80 mole% (inclusive).

6. The flexographic printing plate according to any one of claims 1 to 5, wherein the photocured product has a loss tangent (tan δ) of 0.55 or more at 500 Hz.

7. The flexographic printing plate according to any one of claims 1 to 5, wherein the photocured product has a loss tangent (tan δ) of 0.7 or more at 500 Hz.

8. The flexographic printing plate according to any one of claims 1 to 7, wherein the photosensitive resin composition has a thermoplastic elastomer (a) content of 30% by weight (inclusive) to 85% by weight (inclusive).

9. The flexographic printing plate according to claim 8, wherein the photosensitive resin composition has a thermoplastic elastomer (a) content of 50% by weight (inclusive) to 85% by weight (inclusive).

10. The flexographic printing plate according to any one of claims 1 to 9, wherein the thermoplastic elastomer (a) has a vinyl aromatic hydrocarbon content of 13% by weight (inclusive) to 35% by weight (inclusive).

11. The flexographic printing plate according to any one of claims 1 to 10, wherein the photosensitive resin composition is soluble in an organic solvent for development.

12. The flexographic printing plate according to any one of claims 1 to 11, wherein the photocured product has a Shore A hardness of 50° (inclusive) to 68° (inclusive).

13. The flexographic printing plate according to any one of claims 1 to 12, further comprising a support, wherein the photocured product is formed on the surface of support.

14. A photosensitive resin composition for obtaining the photocured product constituting the flexographic printing plate according to any one of claims 1 to 12.
